# EUROPÄISCHE PATENTSCHRIFT

(11) **EP 3 406 029 B1**
(45) Veröffentlichungstag und Bekanntmachung des Hinweises auf die Patenterteilung: **03.07.2019**
(21) Anmeldenummer: 17700664.0
(22) Anmeldetag: 17.01.2017
(51) Int. Cl.: H02J 13/00, H04B 3/54, H02S 50/00, H02J 3/38

(54) **TRENNVORRICHTUNG FÜR EINEN PHOTOVOLTAISCHEN STRING, SOLARANLAGE UND BETRIEBSVERFAHREN FÜR EINE SOLARANLAGE MIT PHOTOVOLTAISCHEM STRING**
ISOLATOR APPARATUS FOR A PHOTOVOLTAIC STRING, SOLAR INSTALLATION AND OPERATING METHOD FOR A SOLAR INSTALLATION WITH A PHOTOVOLTAIC STRING
DISPOSITIF DE SÉPARATION POUR UNE CHAÎNE PHOTOVOLTAÏQUE, INSTALLATION SOLAIRE ET PROCÉDÉ DE FONCTIONNEMENT POUR INSTALLATION SOLAIRE À CHAÎNE PHOTOVOLTAÏQUE

(30) Priorität: 18.01.2016 DE 102016100758
(43) Veröffentlichungstag der Anmeldung: 28.11.2018
(73) Patentinhaber: SMA Solar Technology AG, 34266 Niestetal (DE)
(72) Erfinder: HOPF, Markus, 34314 Espenau (DE)
(86) Internationale Anmeldenummer: PCT/EP2017/050865
(87) Internationale Veröffentlichungsnummer: WO 2017/125375

(56) Entgegenhaltungen:
- WO-A1-2011/094654
- DE-A1-102007 032 605
- DE-A1-102013 106 808
- US-A1- 2011 260 866
- US-A1- 2013 313 909
- US-A1- 2014 307 811

## Beschreibung

Die Erfindung betrifft eine Trennvorrichtung für einen photovoltaischen String, sowie eine Solaranlage mit einer derartigen Trennvorrichtung. Weiterhin betrifft die Erfindung ein Betriebsverfahren für eine Solaranlage mit photovoltaischem String, mit dem die Trennvorrichtung ansteuerbar ist.

In Solaranlagen wird Sonnenlicht in Wechselstrom umgewandelt, der beispielsweise durch Einspeisung in ein Netz Verbrauchern zur Verfügung gestellt werden kann. Hierzu wird an einen DC-Eingang von Wechselrichtern häufig eine Serienschaltung von Solarmodulen, im Folgenden String oder photovoltaischer (PV-) String genannt, angeschlossen. Durch die Serienschaltung kann der String gerade bei intensiver Sonneneinstrahlung eine hohe Spannung aufweisen, so dass Sicherungsmaßnahmen ergriffen werden müssen, um insbesondere im Fehler- oder Gefahrenfall sicher zu stellen, dass die höchste über den String abfallende Potentialdifferenz zwischen zwei beliebigen Punkten des Strings oder zwischen einem beliebigen Punkt des Strings und dem Erdpotential einen vorgegebenen Grenzwert nicht überschreitet. So kann durch Sicherheitsnormen beispielsweise vorgeschrieben werden, dass im Gefahren- oder Fehlerfall sich der Wechselrichter einerseits vom Netz trennt, und andererseits innerhalb einer vorgegebenen Zeitdauer von wenigen Sekunden die höchste über den String abfallende Potentialdifferenz die Leerlaufspannung eines einzelnen Solarmodules, beispielsweise 80 V, nicht überschreiten darf.

Während Solaranlagen mit Modulwechselrichtern, bei denen an den DC-Eingang jedes Wechselrichters nur ein einzelnes Solarmodul angeschlossen ist, bauartbedingt diese Norm erfüllen, sind bei String-Wechselrichtern zusätzliche Maßnahmen erforderlich. So ist es bekannt, dass die Norm erreicht werden kann, indem jedes Solarmodul kurgeschlossen wird, oder indem eine Anschlussleitung jedes Solarmoduls mit dem Erdpotential elektrisch verbunden wird. Auch eine Auftrennung aller Verbindungsleitungen zwischen Solarmodulen eines Strings führt in bekannter Weise zur Einhaltung der Sicherheitsnorm.

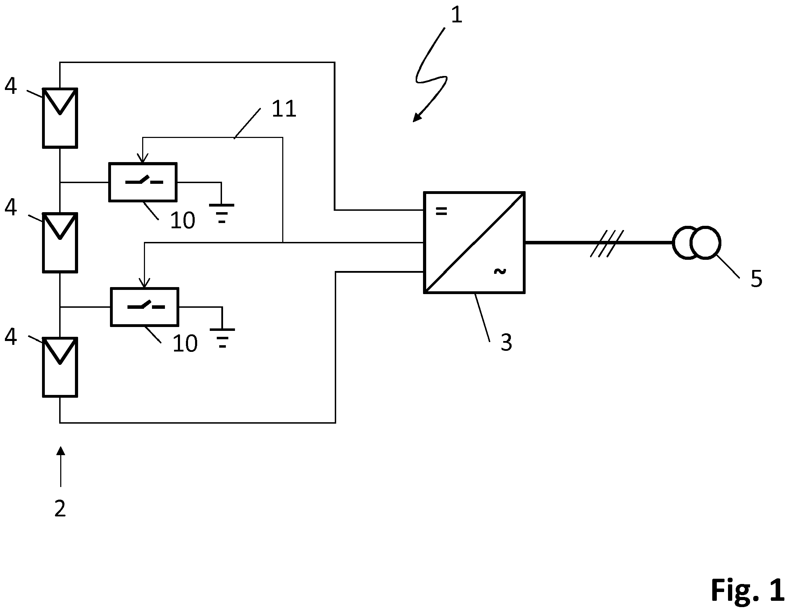

Fig. 1 zeigt eine schematische Darstellung einer Solaranlage 1 nach dem Stand der Technik, bei dem die Verbindungsleitung zwischen benachbarten Solarmodulen 4 eines PV-Strings 2 über ein ansteuerbares Schaltelement 10 mit Erdpotential verbunden werden kann. Ein Wechselrichter 3 kann ein Schließsignal über eine Verbindungsleitung 11 an die Schaltelemente 10 senden, falls ein Gefahren- oder Fehlerfall vorliegt, wodurch zumindest die inneren Solarmodule des PV-Strings 2 kurzgeschlossen werden. Kumulativ oder alternativ dazu ist es ebenfalls möglich, dass eine Verbindungsleitung zwischen äußeren Solarmodulen 4 des PV-Strings 2 und dem Wechselrichter 3 über entsprechende Schaltelemente 10 (in Fig. 1 nicht dargestellt) mit dem Erdpotential verbunden werden. In diesen Ausführungsformen erfolgt die Stromversorgung der Schaltelemente 10 ebenfalls durch den Wechselrichter 3. Nachteilig ist hierbei, dass zusätzliche Leitungen für die Signalübertragung und Stromversorgung erforderlich sind, sowie die Notwendigkeit, die Schaltelemente 10 für die gesamte Stringspannung und den gesamten Stringstrom auslegen zu müssen.

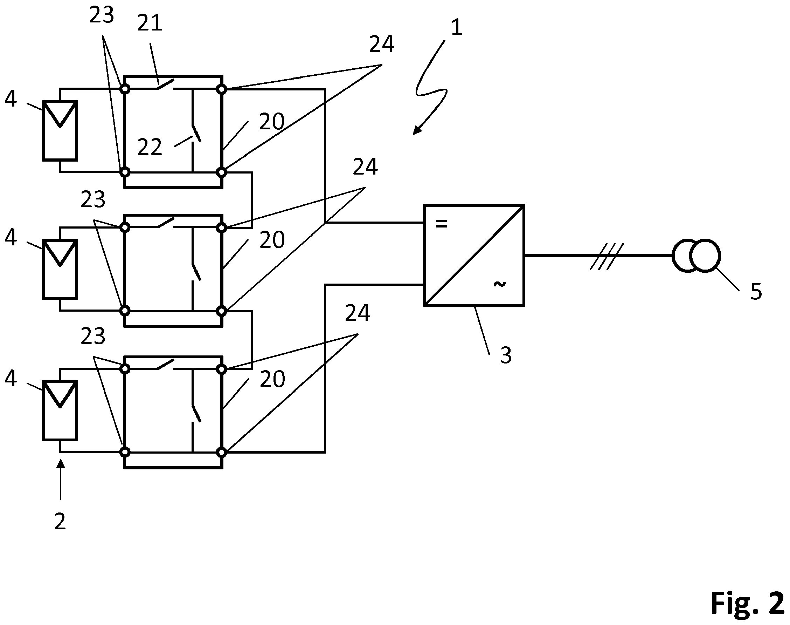

Fig. 2 zeigt eine schematische Darstellung einer weiteren Solaranlage 1 nach dem Stand der Technik. Hier ist jedem Solarmodul 4 eines PV-Strings 2 eine Schutzschaltung 20 zugeordnet, die beispielsweise in einer Anschlussdose des Solarmoduls 4 untergebracht sein kann. Die Schutzschaltung 20 weist einen Eingang 23 zum Anschluss eines der Schutzschaltung 20 zugeordneten Solarmoduls 4 und einen Ausgang 24 zum Anschluss weiterer serienverschalteter Solarmodule 4 des PV-Strings 2 auf. Die Schutzschaltung weist weiterhin einen Trennschalter 21 auf, der zwischen dem Eingang 23 und dem Ausgang 24 der Schutzschaltung 20 angeordnet ist und in der Lage ist, eine elektrische Verbindung zwischen dem Eingang 23 und dem Ausgang 24 herzustellen oder diese aufzutrennen. Kumulativ oder alternativ zu dem Trennschalter 21 weist die Schutzschaltung 20 einen parallel zum Ausgang 24 angeordneten Kurzschlussschalter 22 auf, der in der Lage ist, das Solarmodul 4 bei geschlossenem Trennschalter 21 kurzzuschließen und einen Bypasspfad für den Strom der benachbarten Solarmodule 4 innerhalb des PV-Strings 2 bereitzustellen. Eine Energieversorgung der Schutzschaltung 20 kann durch eine Energieentnahme aus den Solarmodulen 4 erfolgen, so dass ein autarker Betrieb der Schutzschaltung 20 möglich ist. Gleichzeitig kann ein Ansteuersignal für die Schutzschaltung 20 beispielsweise durch hochfrequente Aufmodulation auf den DC-Stringstrom über die Stringleitung (Power-Line-Communication - PLC) übertragen werden. Die Signalerzeugung kann bevorzugt durch den Wechselrichter 3 erfolgen, an den der PV-String 2 angeschlossen ist. Hierdurch entfällt die Notwendigkeit, zusätzliche Leitungen zum Betrieb der Schutzschaltung 20 innerhalb der Solaranlage 1 vorzusehen. Details zur weiteren Ausführung einer solchen Schutzschaltung können der Druckschrift WO 2011/023732 A1 entnommen werden.

Nachteilig bei der Schutzschaltung 20 gemäß Fig. 2 ist der Aufwand einer Nachrüstung einer bestehenden Anlage, sowie die Integration der Schutzschaltung 20 in die Anschlussdose des Solarmoduls 4, da eine unübersichtliche Vielzahl von Anschlussdosen existiert und der Platzbedarf der Schutzschaltung 20 oder andere Integrationsanforderungen regelmäßig nicht erfüllbar ist.

Weiterhin ist in der Druckschrift DE 10 2007 032 605 A1 allgemein eine ansteuerbare Trennbox zur Anordnung zwischen Photovoltaikmodulen offenbart. Die Offenbarung schweigt allerdings unter anderem in Bezug auf eine Versorgung der Schaltung und auf einen Vorgang zur Inbetriebnahme einer Anlage mit getrennten Photovoltaikmodulen.

Auch die Druckschrift DE 10 2011 050 468 A1 beschreibt eine Photovoltaikanlage zum Erzeugen elektrischer Energie mit mehreren in Reihe geschalteten Photovoltaik-Modulen. Dabei ist zwischen wenigstens zwei benachbarten Photovoltaik-Modulen eine Schalteinrichtung angeordnet, mit der die elektrische Verbindung zwischen den benachbarten Photovoltaik-Modulen unterbrochen werden kann.

Die Druckschrift DE 10 2013 106 808 A1 offenbart eine Schaltungsanordnung zur Inline-Spannungsversorgung einer im Bereich einer einen Gleichstrom führenden Leitung angeordneten elektrischen oder elektronischen Einrichtung. Die Schaltungsanordnung weist eine Parallelschaltung von zwei antiparallel ausgerichteten in der Leitung angeordneten Dioden auf. Die über den antiparallelen Dioden abfallende Spannung wird von einer Versorgungsteilschaltung abgegriffen. Den antiparallelen Dioden kann ein Halbleiterschalter zur Minimierung der Verlustleistung der Schaltungsanordnung parallel geschaltet sein.

Die Druckschrift WO 2011 094654 A1 offenbart eine Photovoltaik (PV) - Anlage mit einem Stromrichter, der über Stromschienen mit einer Vielzahl von PV - Strings verbunden ist. Jeder PV-String weist Schalteinheiten auf, die den PV-String in mehrere Abschnitte aufteilen. Um einen Satz von PV-Strings mit dem Stromrichter zu verbinden, wird ein Signal zu den Schalteinheiten in dem Satz der PV-Strings gesendet, woraufhin diese die Abschnitte der PV-Strings des Satzes miteinander verbinden.

Schließlich offenbart die Druckschrift DE 10 20112 104383 A1 eine Schalteinheit zur Anordnung in einer Gleichstromleitung zwischen untereinander in Reihe geschalteten Photovoltaikmodulen. Dabei ist ein Schaltelement der Schalteinheit eingerichtet, einen Stromfluss der Photovoltaikmodule in der Gleichstromleitung zu vermindern. Hierzu weist die Schalteinheit ein Übertragungselement auf, um ein auf der Gleichstromleitung anliegendes elektrisches Steuersignal auszukoppeln und allein mit der Energie des ausgekoppelten Steuersignals das Schaltelement zu steuern. Dabei ist ein Koppelelement parallel zu dem Schaltelement angeordnet, welches bei nichtleitendem Schaltelement das Steuersignal durch die Schalteinheit leitet. Jedoch ist gerade bei einer großen Anzahl von in Reihe geschalteten Photovoltaikmodulen bzw. Schalteinheiten eine signifikante Energieentnahme aus dem Steuersignal zur Energieversorgung und Steuerung des Schaltelementes und gegebenenfalls weiterer Komponenten der Schalteinheit nachteilig. So kann einerseits über das primär der Signalübertragung dienende Steuersignal mit vertretbarem Aufwand nur eine relativ kleine Leistung übertragen werden. Andererseits muss gewährleistet sein, dass auch nach einer Leistungsentnahme aus dem Steuersignal und einer damit verbundenen Reduktion des entsprechenden Signalpegels das Steuersignal noch sicher von allen Schalteinheiten empfangen wird.

Daher ist es Aufgabe der vorliegenden Erfindung, eine Trennvorrichtung für einen photovoltaischen String aufzuzeigen, die keine zusätzlichen Leitungen innerhalb der

Solaranlage erfordert und die leicht in bestehende Solaranlagen integrierbar ist. Dabei soll eine sichere Energieversorgung der Trennvorrichtung auch bei einer großen Anzahl von Trennvorrichtungen innerhalb des Strings gewährleistet sein. Weiterhin ist es Aufgabe der Erfindung, eine entsprechende Solaranlage und ein Betriebsverfahren einer Solaranlage mit einem durch derartige Trennvorrichtungen aufgetrennten PV-String aufzuzeigen, mit denen eine einfache Inbetriebnahme der Solaranlage möglich ist.

Diese Aufgabe wird gelöst durch eine Trennvorrichtung gemäß des unabhängigen Anspruchs 1, durch eine Solaranlage gemäß des nebengeordneten Anspruchs 8, sowie durch ein Betriebsverfahren gemäß des unabhängigen Verfahrensanspruchs 9. Bevorzugte Ausführungsformen sind in den abhängigen Ansprüchen beschrieben.

Erfindungsgemäß umfasst eine Vorrichtung zur Trennung einer elektrischen Verbindung zwischen Solarmodulen eines photovoltaischen Strings einen ersten und einen zweiten Anschluss zur Verbindung mit jeweils einem unterschiedlichen Solarmodul des photovoltaischen Strings, sowie einen Trennschalter, eine Bandsperre und eine Versorgungsschaltung zur Energieversorgung der Trennvorrichtung, die in einer Serienschaltung zueinander zwischen dem ersten und dem zweiten Anschluss angeordnet sind. Ein Bandpass zur Auskopplung eines hochfrequenten Steuersignals aus der elektrischen Verbindung überbrückt den Trennschalter und die Bandsperre parallel. Eine Steuereinheit ist dazu eingerichtet, das Steuersignal zu empfangen und die Trennvorrichtung in Abhängigkeit des Steuersignals zu betreiben. Dabei ist dem Trennschalter eine gegenüber einer Betriebsstromflussrichtung entgegengesetzt gepolte Diode, im Weiteren Rückstromdiode genannt, parallel geschaltet. In dieser Konfiguration kann ein Rückstrom durch den String auch bei geöffnetem Trennschalter fließen. Ebenso kann die Rückstromdiode auch einer Teilserienschaltung des Trennschalters und der Bandsperre parallel geschaltet sein und diese beiden Elemente gemeinsam überbrücken. Dabei kann die Rückstromdiode ein separates Bauteil sein, oder durch eine intrinsische Diode eines parallel zu dem Trennschalter angeordneten ersten Halbleiterschalters gebildet werden. Durch die Versorgungsschaltung wird die Vorrichtung energieautark und kann ihre Leistungsversorgung mit Hilfe des Spannungsabfalls an der Versorgungschaltung selbst sicherstellen. Gegebenenfalls können neben der Trennvorrichtung auch weitere nicht der Trennvorrichtung zugeordnete elektrische Komponenten mit elektrischer Leistung versorgt werden. Dies ist beispielsweise dann vorteilhaft, wenn sich diese Komponenten in örtlicher Nähe zu der Trennvorrichtung befinden. Gleichzeitig kann über den Bandpass eine Wechselspannung geeigneter Frequenz auch bei geöffnetem Trennschalter zwischen den Anschlüssen übertragen werden. Bei der erfindungsgemäßen Trennvorrichtung wird die elektrische Leistung zur Versorgung der Trennvorrichtung und gegebenenfalls der weiteren elektrischen Komponenten im Wesentlichen einem zwischen dem ersten und dem zweiten Anschluss fließenden Gleichstrom entnommen. Es ist daher nicht notwendig, dem Steuersignal einen signifikanten Anteil elektrischer Leistung zur Energieversorgung der Trennvorrichtung zu entnehmen und das Steuersignal dadurch zu dämpfen. Eine Leistungsentnahme aus dem Steuersignal zur Versorgungszwecken ist zwar weiterhin möglich, dient dann jedoch zur Unterstützung der bereits bestehenden Versorgung und kann somit auf ein Minimum reduziert werden.

In einer vorteilhaften Ausführung der Erfindung ist der Trennschalter ein Doppelkontakt-Serienrelais, wobei weiterhin bevorzugt eine Überwachungsschaltung mit einem Mittelpunkt des Doppelkontakt-Serienrelais verbunden ist. Auf diese Weise erhöht sich die Betriebssicherheit der Vorrichtung, weil auch dann eine sichere Trennung der Anschlüsse gewährleistet ist, wenn einer der Kontakte des Doppelkontakt-Serienrelais nicht ordnungsgemäß öffnet. Über die Überwachungsschaltung kann dieser Fehlerfall detektiert und gegebenenfalls darauf geeignet reagiert werden. Alternativ oder ergänzend kann die Überwachungsschaltung auch in vorbekannter Weise das Auftreten eines Lichtbogens bei einem der Kontakte detektieren und durch temporäres Umleiten des Stromes um den betroffenen Kontakt herum löschen. Zusätzlich kann die Überwachungsschaltung in vorbekannter Weise auch durch ein bewusst herbeigeführtes temporäres Umleiten des Stromes bereits vor einem Schaltvorgang des Trennschalters das Entstehen eines Schaltlichtbogens verhindern.

Der Leistungsbedarf der Vorrichtung wird verringert, wenn der Trennschalter ein bistabiles Relais ist, weil dann lediglich in den Momenten der Betätigung des Relais Leistung benötigt wird, während eine Leistung zum Halten eines Schaltzustandes, der durch einen zuvor erfolgten Schaltvorgang eingestellt wurde, entfällt. Gegebenenfalls ist ein Energiespeicher vorzusehen, aus dem der Trennschalter betätigt wird, um bei Ausfall der Energieversorgung noch ein zuverlässiges Öffnen des Trennschalters sicherzustellen.

Grundsätzlich kann der Trennschalter aber nicht nur als Relais, sondern auch als Halbleiterschalter oder als eine serienverschaltete Kombination aus beiden ausgebildet sein. Die Verwendung eines Halbleiterschalters als Trennschalter ist insbesondere dann möglich, wenn eine galvanische Trennung der Anschlüsse bei geöffnetem Trennschalter nicht gefordert ist. Bei Verwendung von Halbleiterschaltern als Trennschalter können auch Schalter eingesetzt werden, die eine gegenüber der maximalen Stringspannung geringere Sperrspannung aufweisen, indem diese mit einer Schutzschaltung ausgestattet sind, die die Halbleiterschalter bei Anliegen einer einen Grenzwert übersteigenden Spannung vorübergehend kurzschließen. Sofern eine galvanische Trennung aber erforderlich ist, ist der Einsatz von Relais als Trennschalter vorzuziehen, und auch der Bandpass sollte als galvanisch trennender Bandpass ausgelegt sein, z.B. durch einen darin enthaltenen Serienkondensator.

Vorteilhafterweise wird dem Trennschalter ein erster Halbleiterschalter zur Vermeidung eines Schaltlichtbogens parallel geschaltet. Der erste Halbleiterschalter wird bei oder vor einem Öffnen des Trennschalters vorübergehend in den leitenden Zustand versetzt, sodass der Strom ausreichend lange auf den ersten Halbleiterschalter kommutiert und keinen Lichtbogen beim Öffnen des Trennschalters verursachen kann. Nach dem Öffnen des Trennschalters wird der erste Halbleiterschalter wieder in den nicht leitenden Zustand versetzt und unterbricht damit den auf ihn kommutierten Strom. Alternativ kann der erste Halbleiterschalter auch einer Teilserienschaltung des Trennschalters und der Bandsperre parallel geschaltet sein und diese beiden Elemente gemeinsam überbrücken.

In einer bevorzugten Ausführung der Erfindung umfasst die Versorgungsschaltung eine Kleinspannungsvorrichtung. Ein DC/DC-Wandler, insbesondere ein Hochsetzsteller, ist mit der Kleinspannungsvorrichtung verbunden und dazu eingerichtet, eine an der Kleinspannungsvorrichtung abfallende Spannung in eine geeignete Versorgungsspannung für die Trennvorrichtung, gegebenenfalls auch für weitere elektrische Komponenten, umzuwandeln.

Die Kleinspannungsvorrichtung weist bevorzugt zwei antiparallel geschaltete Dioden auf. Durch diese Schaltung wird die über der Kleinspannungsvorrichtung abfallende maximale Spannung begrenzt bzw. weitgehend unabhängig vom Laststrom zwischen den Anschlüssen der Trennvorrichtung. Zusätzlich ist damit die Kleinspannungsvorrichtung bidirektional funktionsfähig unabhängig davon, ob ein Strom in Betriebsstromrichtung oder ein Rückstrom entgegen der Betriebsstromrichtung vorliegt.

Der Kleinspannungsvorrichtung kann weiterhin ein zweiter Halbleiterschalter parallel geschaltet sein, um den Spannungsabfall bzw. die damit verbundenen Leistungsverluste gering zu halten, indem der zweite Halbleiterschalter ganz oder zumindest teilweile geschlossen wird, wenn der volle Spannungsabfall über die Kleinspannungsvorrichtung nicht benötigt wird, um die Trennvorrichtung mit Energie zu versorgen. Der zweite Halbleiterschalter kann auch zwischen zwei Schaltzuständen, z.B. offen und geschlossen, hin und her geschaltet werden. In einer bevorzugten Ausführungsform bildet eine intrinsische Diode des zweiten Halbleiterschalters einen Bestandteil der Kleinspannungsvorrichtung, so dass der zweite Halbleiterschalter auch Teil der Kleinspannungsvorrichtung sein kann.

In einem weiteren Aspekt der Erfindung weist eine Solaranlage einen Wechselrichter und einen an den Wechselrichter angeschlossenen photovoltaischen String mit mindestens zwei seriell geschalteten Solarmodulen auf, zwischen denen eine vorstehend beschriebene Trennvorrichtung angeordnet ist. Weist der photovoltaische String mehr als zwei Solarmodule auf, ist bevorzugt jeweils zwischen zwei benachbarten Solarmodulen eine vorstehend beschriebene Trennvorrichtung angeordnet. Sofern die Sicherheitsnorm im Fehlerfall eine maximale Spannung innerhalb des Strings erlaubt, die ein Mehrfaches, beispielsweise das Doppelte einer Leerlaufspannung eines Solarmoduls entspricht, ist es nicht erforderlich, dass zwischen allen Solarmodulen jeweils eine Trennvorrichtung angeordnet ist. Vielmehr können entsprechend große Gruppen, beispielsweise Paare, direkt verbundener Solarmodule im String angeordnet sein, die untereinander jeweils durch eine Trennvorrichtung voneinander getrennt sind.

In noch einem weiteren Aspekt der Erfindung umfasst ein Betriebsverfahren für eine Solaranlage, die einen Wechselrichter und einen an den Wechselrichter angeschlossenen photovoltaischen String mit mindestens zwei seriell geschalteten Solarmodulen aufweist, zwischen denen eine vorstehend beschriebene Trennvorrichtung angeordnet ist, ein Bereitstellen einer initialen Energieversorgung für die geöffnete Trennvorrichtung durch ein Aufprägen eines Stromflusses über den String und einer Energieentnahme aus dem aufgeprägten Stromfluss. Anschließend erfolgt ein Senden eines Einschaltsignals über den String, was zu einem Schließen eines Trennschalters der Trennvorrichtung in Reaktion auf das gesendete Einschaltsignal führt. Auch nach dem Schließen des Trennschalters der Trennvorrichtung erfolgt eine Energieversorgung der Trennvorrichtung durch den Stromfluss über den String, der jetzt aber nicht mehr aufgeprägt, sondern durch die Solarmodule erzeugt wird. Bei dem Bereitstellen der initialen Energieversorgung für die geöffnete Trennvorrichtung wird das Aufprägen des Stromflusses durch das Aufprägen eines Rückstroms über den String realisiert. Hierzu wird eine Spannung an den String angelegt, die die Leerlaufspannung des Strings überschreitet. Eine derartige Spannung kann beispielsweise dadurch erzeugt werden, dass ein Zwischenkreiskondensators des Wechselrichters aus dem Netz auf eine bestimmte Gleichspannung - beispielsweise eine einfache oder eine doppelte Netzkuppenspannung - aufgeladen wird. Falls die Gleichspannung am Zwischenkreiskondensator unterhalb oder weit oberhalb der Leerlaufspannung des Strings liegt, so kann ein DC/DC-Wandler- beispielsweise ein zwischen dem Zwischenkreiskondensator und dem String angeordneter bidirektional betreibbarer DC/DC-Wandler des Wechselrichters - die Gleichspannung entsprechend hochsetzen oder tiefsetzen, um einen gewünschten Rückstrom über den String aufzuprägen.

Wenn die Trennvorrichtung geschlossen ist, wird in einer bevorzugten Variante des erfindungsgemäßen Verfahrens wiederholt oder dauerhaft ein Lebenssignals über den String gesendet, wobei die Trennvorrichtung geschlossen bleibt, solange das Lebenssignal gesendet wird, und sich bei Wegfall des Lebenssignals öffnet.

Der Wegfall des Lebenssignals kann durch das Betätigen eines manuellen Sicherheitsschalters oder auch durch das Erkennen eines Fehler- oder Gefahrenfalls durch Komponenten der Solaranlage bewirkt werden. Auch bei einer Trennung vom Netz kann der Wegfall des Lebenssignals ausgeführt werden. Dabei ist es unerheblich, ob das Lebenssignal vom Wechselrichter oder einer anderen Komponente der Solaranlage erzeugt wird.

In einer Ausführungsform der Erfindung erfolgt zusätzlich zu dem Aufprägen des Rückstroms das Aufprägen des Stromflusses durch ein Anlegen einer Wechselspannung an den String mit einer ersten Frequenz. Mit Anlegen einer Wechselspannung ist hierbei nicht nur die elektrische Verbindung mit einer Wechselspannungsquelle gemeint, sondern auch andere Arten der Spannungserzeugung wie induktives oder kapazitives Einkoppeln.

Das Senden des Lebenssignals kann durch ein Anlegen einer Wechselspannung mit einer zweiten, von der ersten Frequenz unterschiedlichen Frequenz erfolgen, die zweite Frequenz kann aber auch gleich der ersten Frequenz sein, die bevorzugt bei einer Frequenz erfolgt, in der die Wechselspannung effektiv und verlustarm über den Bandpass geleitet wird. Das Aufprägen des Stromflusses erfolgt bevorzugt durch den an den String angeschlossenen Wechselrichter. Es ist aber auch denkbar, dass zusätzlich zum Wechselrichter und zum String eine weitere Komponente in der Anlage verbaut ist, die die Funktion des Aufprägens des Stromflusses und damit die initiale Energieversorgung der Trennvorrichtung übernimmt. Auch das Senden des Lebenssignals erfolgt bevorzugt durch den Wechselrichter, kann aber auch durch die zusätzliche Komponente durchgeführt werden.

Im Folgenden wird die Erfindung mithilfe von Figuren dargestellt, von denen
- Fig. 1: eine erste vorbekannte Ausführung einer Solaranlage mit schaltbarer Erdung innerhalb einer Stringleitung,
- Fig. 2: eine zweite vorbekannte Ausführung einer Schutzschaltung für Solarmodule einer Solaranlage mit PV-String,
- Fig. 3: eine schematische Darstellung einer erfindungsgemäßen Solaranlage mit Trennvorrichtungen innerhalb eines Strings,
- Fig. 4: einen schematischen Aufbau einer erfindungsgemäßen Trennvorrichtung,
- Fig. 5: eine bevorzugte Ausgestaltung einer erfindungsgemäßen Trennvorrichtung, sowie
- Fig. 6: ein Ablaufdiagramm eines erfindungsgemäßen Betriebsverfahrens für eine Solaranlage zeigt.

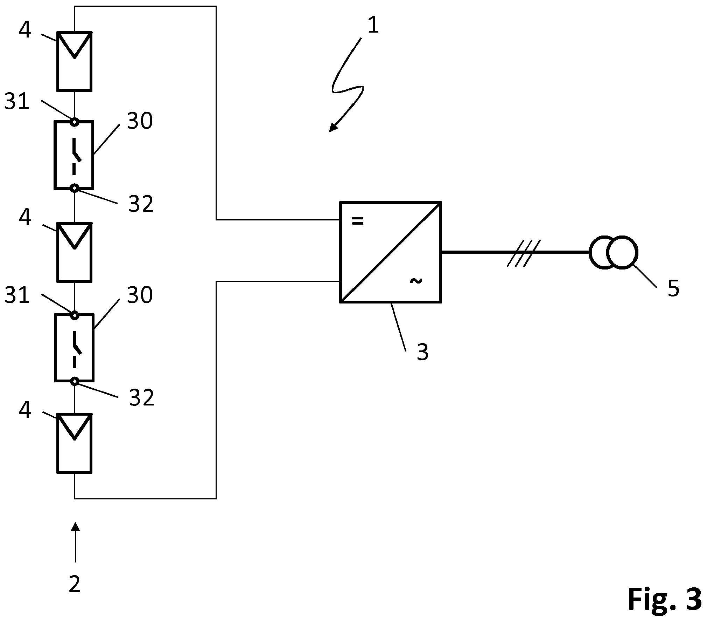

Fig. 3 zeigt einen schematischen Aufbau einer erfindungsgemäßen Solaranlage 1 mit einem Wechselrichter 3, an den eingangsseitig ein String 2 mit einer Serienschaltung einer Vielzahl von Solarmodulen 4 angeschlossen ist. Der Wechselrichter 3 ist ausgangseitig, hier als dreiphasiger Wechselrichter, an ein Netz 5 angeschlossen. Der Wechselrichter 3 kann aber auch als einphasiger oder mehrphasiger Wechselrichter 3 ausgeführt sein. Zwischen je zwei der Solarmodule 4 ist eine Trennvorrichtung 30 angeordnet. Jede Trennvorrichtung 30 kann auf diese Weise durch Öffnen eines darin enthaltenen ansteuerbaren Schaltelementes die Serienschaltung der Solarmodule 4 auftrennen. Die Trennvorrichtung 30 kann an einer beliebigen Stelle der Verbindungsleitung der zugeordneten beiden Solarmodule 4 angebracht sein. Eine Integration der Trennvorrichtungen 30 kann auch nachträglich durch Auftrennen einer bestehenden Verbindungsleitung zwischen zwei benachbarten Solarmodulen 4 und Verbinden der aufgetrennten Enden der Verbindungsleitung mit entsprechenden Anschlüssen 31, 32 der Trennvorrichtung 30 erfolgen. Hierbei ist es denkbar, dass Stecker an den aufgetrennten Enden angebracht werden, die in entsprechende Gegenstecker der Trennvorrichtung eingeführt werden, oder dass die aufgetrennten Enden direkt in entsprechende Anschlüsse 31, 32 eingeführt und fixiert werden, beispielsweise durch Klemmen, Löten, Schrauben oder mittels metallischer Schneidelemente. In Fig. 3 ist exemplarisch ein String 2 mit serienverschalteten Solarmodulen 4 gezeigt, wobei zwischen zwei benachbarten Solarmodulen 4 jeweils eine Trennvorrichtung 30 angeordnet ist. Im allgemeinen Fall von n Solarmodulen 4 innerhalb des Strings sind somit (n-1) Trennvorrichtungen 30 erforderlich. Die Anzahl der erforderlichen Trennvorrichtungen 30 relativ zur Anzahl n der Solarmodule 4 kann jedoch - abhängig von einer erlaubten maximalen Spannung innerhalb des PV-Strings 2 auch reduziert werden, indem Gruppen mehrerer Solarmodule 4 direkt und ohne zwischengeschaltete Trennvorrichtung 30 miteinander verbunden werden. Dies ist aus Kostengründen zweckmäßig, solange die direkt miteinander verbundenen Solarmodule 4 die erlaubte maximale Spannung nicht überschreiten.

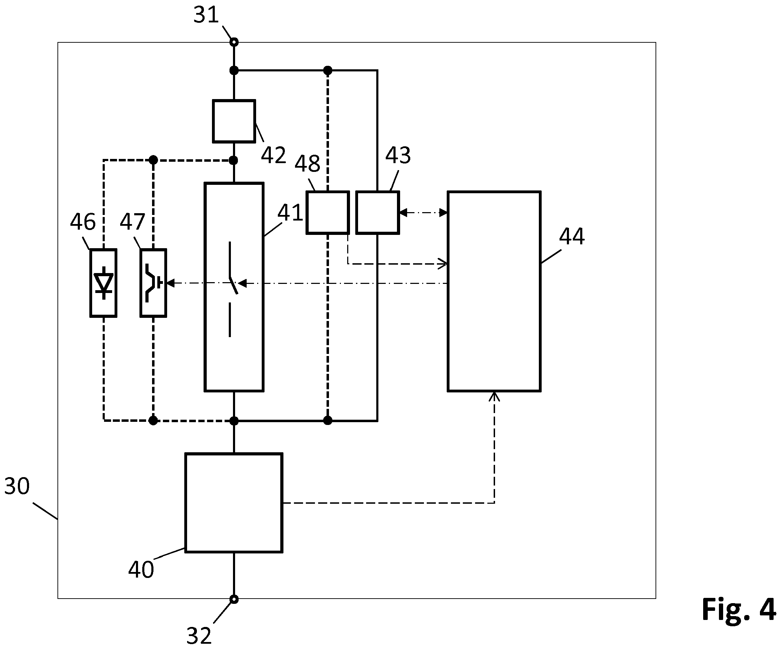

Einen schematischen Aufbau einer erfindungsgemäßen Trennvorrichtung 30 zeigt Fig. 4. Zwischen dem ersten Anschluss 31 und dem zweiten Anschluss 32 ist eine Serienschaltung einer Bandsperre 42, eines Trennschalters 41 und einer Versorgungsschaltung 40 angeordnet. Ein Bandpass 43 überbrückt die Bandsperre 42 und den Trennschalter 41, so dass bei geschlossenem, aber auch bei geöffnetem Trennschalter 41 ein über die Anschlüsse 31, 32 übertragenes Wechselspannungssignal über den Bandpass 43 geleitet, ausgekoppelt und an eine Steuereinheit 44 übermittelt wird. Die Steuereinheit 44 ist zur Ansteuerung des Trennschalters 41 in Reaktion auf das übertragene Signal eingerichtet. Dem Trennschalter 41 ist eine Rückstromdiode 46 und/oder ein erster Halbleiterschalter 47 parallel geschaltet sein. Die Rückstromdiode 46 kann als separates Bauteil vorliegen, oder durch die intrinsische Diode des ersten Halbleiterschalters 41 gebildet werden. Der erste Halbleiterschalter 47 wird ebenfalls von der Steuereinheit 44 angesteuert und kann insbesondere zur Vermeidung von Lichtbögen im Trennschalter 41 eingesetzt werden.

Die Versorgungsschaltung 40 dient der Energieversorgung der Steuereinheit 44, indem sie zumindest bei geschlossenem Trennschalter 41 bei einem zwischen den Anschlüssen 31, 32 fliesendem Strom einen geeigneten Spannungsabfall bewirkt und hieraus die für die Versorgung der Steuereinheit 44 erforderliche Energie erzeugt. In einer ersten Variante der Erfindung ist die Versorgungsschaltung 40 gleichzeitig auch dazu eingerichtet, die für den Betrieb der Steuereinheit 40 erforderliche Energie bei geöffnetem Trennschalter 41 aus dem über den Bandpass 43 geleiteten Wechselspannungssignal zu erzeugen. Alternativ kann dem Bandpass 43 aber auch eine zweite Versorgungsschaltung 48 parallel geschaltet sein, die einen Teil des Wechselspannungssignals übernimmt und zur Energieversorgung der Steuereinheit 44 nutzt. Denkbar, aber nicht gezeigt, sind eine serielle Anordnung der zweiten Versorgungsschaltung und des Bandpasses 43, sowie eine Ausführung, in der der Bandpass 43 und die zweite Versorgungsschaltung 48 eine gemeinsame Komponente der erfindungsgemäßen Trennvorrichtung 30 bilden.

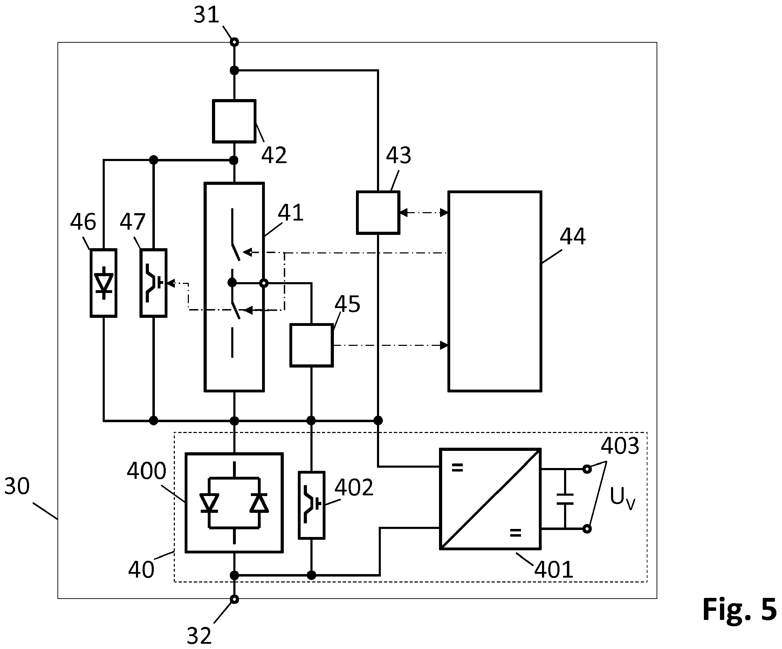

Der Aufbau einer erfindungsgemäßen Trennvorrichtung 30 ist detaillierter in der Fig. 5 illustriert. Der erste Anschluss 31 ist hier in einer Serienschaltung über eine Kleinspannungsvorrichtung 400, den Trennschalter 41 und die Bandsperre 42 mit dem zweiten Anschluss 32 der Trennvorrichtung 30 verbunden. Diese Serienschaltung stellt den Laststrompfad dar, über den ein Gleichstrom eines Strings 2, in den die Trennvorrichtung 30 integriert ist, fließt, wenn der Trennschalter 41 geschlossen ist. Der Bandpass 43 ist einseitig mit einer dem Trennschalter 41 abgewandten Seite der Bandsperre 42 und anderseitig mit einem Verbindungspunkt zwischen Trennschalter 41 und Kleinspannungsvorrichtung 400 verbunden, so dass der Bandpass 43 die Teilserienschaltung von Trennschalter 41 und Bandsperre 42 überbrückt. Der Bandpass 43 kann als Serienschaltung eins Kondensators und einer Spule ausgeführt sein. Eine Steuereinheit 44 ist mit dem Bandpass 43 gekoppelt, um eine auf die spezifische Frequenz des Bandpass/Bandsperre-Paares abgestimmte Frequenzkomponente des Stringstroms, welche sowohl bei geöffnetem als auch bei geschlossenem Trennschalter über den Bandpass 43 zwischen dem ersten Anschluss 31 und dem zweiten Anschluss 32 übertragen wird, als Signal zu empfangen. Die Steuereinheit 44 ist in der Lage, die Trennvorrichtung 30 in Reaktion auf das Signal zu steuern, insbesondere den Trennschalter 41 entsprechend zu betätigen. Auf diese Weise kann die Steuereinheit 44 mittels Power-Line-Communication (PLC) durch ein auf den Laststrom des Strings 2 aufmoduliertes Signal gezielt angesprochen werden bzw. ihrerseits ein Antwortsignal auf den Laststrom aufmodulieren und somit bidirektional mit einem Wechselrichter 3, an den der String 2 angeschlossen ist, kommunizieren.

Die Kleinspannungsvorrichtung 400 bildet in dieser Ausführung einen Bestandteil einer Versorgungsschaltung 40 zum Betrieb der Trennvorrichtung 30. Hierzu ist sie dazu eingerichtet, einen Spannungsabfall zu produzieren, der einerseits so gering wie möglich sein soll, insbesondere im Fall eines hohen Laststromes bei geschlossenem Trennschalter 41, da dieser Spannungsabfall einen im Prinzip unerwünschten Leistungsverlust des PV-Strings 2 darstellt. Andererseits muss er auch bei den niedrigsten Lastströmen eines ordnungsgemäßen Betriebs der Solaranlage so hoch sein, dass hieraus ausreichend Leistung zur zuverlässigen Versorgung der Trennvorrichtung erzeugt werden kann. Bevorzugt umfasst die Kleinspannungsvorrichtung hierzu eine antiparallele Schaltung von zwei Dioden, insbesondere Silizium-Dioden, so dass ein vom Laststrom möglichst unabhängiger Spannungsabfall im Bereich von 1V erzeugt wird, wodurch in der Versorgungsschaltung 40 kostengünstige Niedervolt-Bauelemente verwendet werden können. Der Kleinspannungsvorrichtung 400 ist ein DC/DC-Wandler 401 parallel geschaltet, um diese relativ geringe Spannung auf einen typischen Wert einer Versorgungsspannung U_{V}, z.B. 5V, hochzusetzen, die dann an den Versorgungsanschlüssen 403 der Versorgungsschaltung 40 anliegt, um die anderen Komponenten der Trennvorrichtung 30 mit Energie zu versorgen. Insbesondere kann die Steuereinheit 44 über die an den Versorgungsanschlüssen 403 der Versorgungsschaltung 40 anliegende Versorgungsspannung U_{V} versorgt werden. Es ist gleichfalls möglich, die Versorgungsanschlüsse 403 der Trennvorrichtung 33 nach außen zu führen und, beispielsweise als separate Anschlüsse in einer Gehäusewand der Trennvorrichtung 30, von außen her zugänglich zu gestalten. Auf diese Weise können auch weitere elektrische Komponenten, die nicht der Trennvorrichtung zugeordnet sind, sich aber in örtlicher Nähe zu der Trennvorrichtung befinden, von der Trennvorrichtung 30 beziehungsweise von deren Versorgungsschaltung 40 mit elektrischer Leistung versorgt werden.

In einer vorteilhaften Ausführungsform der Erfindung ist der Kleinspannungsvorrichtung 400 zusätzlich ein zweiter Halbleiterschalter 402, beispielsweise ein MOSFET, insbesondere ein normally-open MOSFET, zur Verminderung des Spannungsabfalls parallel geschaltet, der immer dann ganz oder teilweise leitend geschaltet, insbesondere im Linearbetrieb mit einem vom Stringstrom unabhängigen, konstanten Spannungsabfall betrieben wird, wenn nicht der durch die Dioden erzeugte Spannungsabfall, sondern nur ein geringerer Wert von beispielsweise 300mV zur Erzeugung der Versorgungsleistung benötigt wird. Auf diese Weise kann die innerhalb der Trennvorrichtung 30 dem String 2 entzogene Verlustleistung weiter reduziert werden. Es liegt im Rahmen der Erfindung, dass ein zweiter Halbleiterschalter 402 eine intrinsische Diode (i. e. eine sogenannte Body-Diode) aufweist, wobei eine der antiparallel verschalteten Dioden der Kleinspannungsvorrichtung 400 durch die intrinsische Diode des zweiten Halbleiterschalters 402 verkörpert werden kann. Gleichfalls ist es jedoch möglich, dass trotz vorhandener intrinsischer Diode des zweiten Halbleiterschalters 402 zwei separate Dioden antiparallel verschaltet werden. Dies ist beispielsweise dann sinnvoll, wenn eine vorhandene intrinsische Diode des zweiten Halbleiterschalters 402 einen gewünschten Spannungsabfall nicht hervorruft, während hingegen zwei separate antiparallel verschaltete Dioden dem gewünschten Spannungsabfall zumindest näher kommen.

In einem Ausführungsbeispiel der Erfindung benötigt die Trennvorrichtung 30 eine Leistung von 30mW zum sicheren Betrieb. Der String 2 der Solaranlage 1 hat einen maximalen Strom von 10 A und soll bis hinab zu einem Stringstrom von 100mA in Betrieb gehalten werden. Bei geschlossenem bzw. linear betriebenen zweiten Halbleiterschalter 402, also einem Spannungsabfall von 300mV kann durch den Betrieb des DC/DC-Wandlers 401 so bei 100mA Stringstrom gerade die erforderliche Leistung von 30mW erzeugt werden, gegebenenfalls kann der Spannungsabfall durch Öffnen des zweiten Halbleiterschalters 402 vorübergehend oder dauerhaft erhöht werden. Gleichzeitig bleibt bei maximalem Laststrom von 10A die Verlustleistung auf 3W(=10A*300mV) begrenzt.

Der Trennschalter 41 ist in einer bevorzugten Ausführungsform als Doppelkontakt-Serienrelais ausgeführt, hat also zwei Relaiskontakte, die in Serie geschaltet sind. Dies erhöht zum einen die Betriebssicherheit der Trennvorrichtung 30, da auch in dem Fall, bei dem ein Kontakt des Trennschalters 41 zum Beispiel aufgrund einer Kontaktverschweißung durch einen zuvor aufgetretenen Lichtbogen nicht öffnet, dennoch eine sichere Trennung durch die Trennvorrichtung 30 erfolgt. Gleichzeitig kann durch Verbinden eines Mittelpunktes zwischen den beiden Relaiskontakten mit einer Überwachungsschaltung 45 dieser Fall detektiert und weitergemeldet werden, bevor die Trennvorrichtung 30 funktionsuntüchtig wird. Zur Weitergabe der Information über den Zustand des Trennschalters 41 ist die Überwachungsschaltung 45 bevorzugt mit der Steuereinheit 44 verbunden. Eine Weitergabe dieser Information von der Steuereinheit 44 an den Wechselrichter 3 kann mittels Power-Line-Communication (PLC) erfolgen. Der Wechselrichter 3 kann seinerseits diese Information über eine im Wechselrichter vorhandene Kommunikationsschnittstelle drahtgebunden oder per Funk an einen Betreiber der PV-Anlage senden und diesen somit über einen risikobehafteten Zustand der PV-Anlage informieren. Sollte die Überwachungsschaltung 45 detektieren, dass ein Kontakt des Trennschalters 41 im Gegensatz zu einem Sollzustand nicht geöffnet ist, ist eine Ein-Fehler-Sicherheit der Anordnung nicht mehr gewährleistet und ein Schließen des Trennschalters 41 kann durch die Steuerung 44 verhindert werden.

Um den Leistungsbedarf der Trennvorrichtung 30 weiter zu reduzieren, ist es vorteilhaft, den Trennschalter 41 als bistabiles Relais auszuführen, sodass der Trennschalter 41 nur Leistung während der Schaltphasen, nicht aber zum Halten eines zuvor herbeigeführten Schaltzustandes benötigt. Um sicherzustellen, dass im Fehlerfall oder bei unerwartetem Ausfall der Energieversorgung der Trennschalter 41 automatisch öffnet, ist es vorteilhaft, einen Kondensator zum Speichern der für das Öffnen benötigten Energie vorzusehen.

Zur Vermeidung von Schaltlichtbögen ist dem Trennschalter 41 ein erster Halbleiterschalter 47 parallel geschaltet. Der erste Halbleiterschalter 47 ist in dem Moment leitend geschaltet, in dem der Trennschalter 41 das Signal zum Öffnen erhält. Beim Öffnen der Kontakte des Trennschalters 41 kommutiert der Strom auf den ersten Halbleiterschalter 47, sodass ein Lichtbogen im Trennschalter 41 beim Öffnen der Kontakte nicht entstehen kann. Sobald die Kontakte geöffnet sind, wird der erste Halbleiterschalter 47 ebenfalls geöffnet und der Strom, zumindest jedoch ein Gleichstromanteil des Stromes zwischen dem ersten Anschluss 31 und dem zweiten Anschluss 32 wird unterbrochen.

In einer bevorzugten Ausführungsform der Erfindung ist dem Trennschalter 41 weiterhin eine Rückstromdiode 46 parallel geschaltet, die derart gepolt ist, dass ein dem normalen Laststrom des Strings 2 entgegen gerichteter Strom auch bei geöffnetem Trennschalter 41 durch die Trennvorrichtung 30 fließen kann. Diese Variante der Erfindung erlangt bei einem weiter unten beschriebenen Betriebsverfahren für eine Solaranlage besondere Bedeutung, bei der zur initialen Energieversorgung der Trennvorrichtung 30 zeitweise ein Rückstrom durch den String 2 getrieben wird

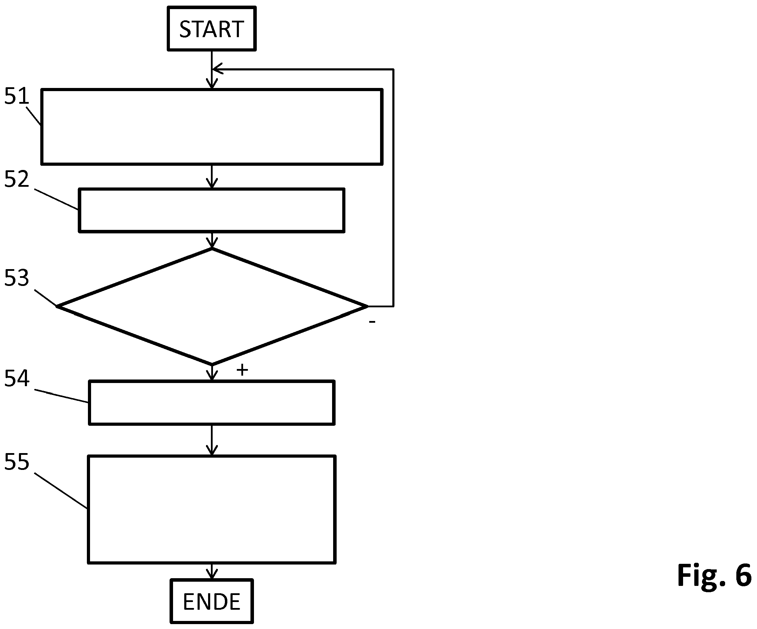

Ein erfindungsgemäßes Betriebsverfahren einer Solaranlage 1 ist als Flussdiagramm in Fig. 6 beschrieben. In einem Ausgangszustand dieses Verfahrens wird angenommen, dass der String 2 der vorstehend beschriebenen Solaranlage 1 noch keine Energie produziert und alle Trennvorrichtungen 30 des Strings 2 im geöffneten Zustand sind. Durch die Trennung der Solarmodule 4 des Strings 2 untereinander ist sichergestellt, dass kein Punkt der Anlage eine Spannung aufweist, die die Leerlaufspannung eines der Solarmodule 4 übersteigt.

In einem ersten Schritt 51 wird jetzt eine initiale Energieversorgung für die Trennvorrichtung 30 bei geöffnetem Trennschalter 41 bereitgestellt, indem dem String 2 ein Stromfluss aufgeprägt wird. Die Form des Stromflusses ist so gewählt, dass die Trennvorrichtung 30 des Strings 2 trotz des geöffneten Trennschalters 41 vom Strom durchflossen wird. Bei dem Aufprägen des Stromflusses wird ein Rückstrom beispielsweise in Form eines Gleichstroms auf den String 2 aufgeprägt, der der normalen Stromflussrichtung des Strings entgegen gerichtet ist. In diesem Fall umgeht der Strom den geöffneten Trennschalter 41 über die parallel geschaltete Rückstromdiode 46. In einer Ausführungsform kann der Stromfluss zusätzlich zu dem Rückstrom in Form eines Wechselstromes mit einer ersten Frequenz über ein Anlegen einer Wechselspannung an den String mit der ersten Frequenz erzeugt werden, wobei die erste Frequenz so gewählt ist, dass sie den Bandpass 43 passieren kann. Es ist unabhängig von der gewählten Stromform - i. e. einem Rückstrom z.B. in Form eines Gleichstromes, oder einem Wechselstrom - denkbar, dass der Wechselrichter 3 den Strom aufprägt, oder dass eine eigenständige Komponente hierfür in die Solaranlage 1 integriert ist. In jedem Fall durchfließt der aufgeprägte Strom die Kleinspannungsvorrichtung 400 der jeweiligen Trennvorrichtung 30 und erzeugt dort einen Spannungsabfall, der über den gegebenenfalls parallel geschalteten DC/DC-Wandler 401 genutzt wird, um die initiale Energieversorgung bereitzustellen und einen Ausgangskondensator zwischen den Versorgungsanschlüssen 403 der Versorgungsschaltung 40 vorzuladen.

In einer vorteilhaften Variante des Verfahrens sendet jede Trennvorrichtung 30, zum Beispiel über ihre Steuereinheit 44, ein individuelles PLC-Signal, sobald die initiale Energieversorgung zu einem ausreichenden Versorgungszustand für die Trennvorrichtung 30 geführt hat. Dieses Signal wird vom Wechselrichter 3 bzw. der eigenständigen Komponente empfangen und zur Wahl der Dauer der initialen Energieversorgungsphase verwendet, insbesondere indem der folgende Schritt erst nach Erhalt eines individuellen Signals von allen Trennvorrichtungen 30 des Strings 2 durchgeführt wird.

Sobald an den Versorgungsanschlüssen 403 der Versorgungsschaltung 40 eine ausreichende Spannung anliegt, um die Trennvorrichtung 30 zu betreiben, wird in einem zweiten Schritt 52 über den Wechselrichter 3 bzw. die eigenständige Komponente ein Einschaltsignal über den String gesendet. Bevorzugt kann das Einschaltsignal als PLC-Signal gesendet werden. In Reaktion auf das gesendete Einschaltsignal schließen die jeweiligen Trennvorrichtungen 30 in einem dritten Schritt 53 ihren Trennschalter 41 und es wird geprüft, ob alle Trennschalter 41 des Strings 2 geschlossen sind. Ist dies der Fall, kann als Folge die von den Solarmodulen 4 erzeugte Leistung als Laststrom durch den String 2 zum Wechselrichter 3 fließen, wo sie in netzkonformen Wechselstrom umgewandelt und in das angeschlossene Netz 5 eingespeist wird. Sollte eine der Trennvorrichtungen 30 des Strings 2 ihren Trennschalter 41 nicht schließen, und damit der Laststrom nicht fließen, kann der Vorgang mit dem ersten Schritt 51, gegebenenfalls mit einer verlängerten initialen Energieversorgungsphase, wiederholt werden.

Solange die Solaranlage sich in einem normalen Betriebszustand befindet, können die Trennvorrichtungen 30 sich über den in den Kleinspannungsvorrichtungen 400 durch den Laststrom verursachten Spannungsabfall weiter versorgen. Es wird in diesem Zustand in einem vierten Schritt 54 des Verfahrens ein Lebenssignal, bevorzugt als PLC-Signal, besonders bevorzugt vom Wechselrichter 3, auf den Laststrom als wiederholtes Signal oder als dauerhaftes Signal aufmoduliert. Alternativ können andere Signale oder andere Signalgeber, zum Beispiel weitere Anlagenkomponenten, Verwendung finden. Als Trägerfrequenz eines Lebenssignals in Form einer Wechselspannung kann die erste Frequenz oder eine zweite, von der ersten Frequenz unterschiedliche Frequenz verwendet werden. Bei Wahl der gleichen, ersten Frequenz kann bevorzugt die spezifische Frequenz des Bandpass/Bandsperre-Paares gewählt werden, wodurch minimale Signalverluste innerhalb des Strings 2 und damit der zuverlässige Signalempfang in den Trennvorrichtungen 30 auch bei einer hohen Anzahl von Solarmodulen 4 innerhalb des Strings 2 möglich sind.

Solange das Lebenssignal von den Trennvorrichtungen 30 empfangen wird, bleiben die Trennschalter 41 der Trennvorrichtungen 30 des Strings 2 geschlossen. Bei Wegfall des Lebenssignals jedoch öffnen die Trennvorrichtungen 30 in einem Schritt 55 eigenständig ihren Trennschalter 41, wodurch der Laststrom des Strings 2 unterbrochen wird. Auf diese Weise werden alle Solarmodule 4 des Strings 2 innerhalb kurzer Zeitdauer elektrisch voneinander getrennt und die Solaranlage 1 in einen sicheren Zustand durch Unterschreiten des Grenzwertes für die maximale Spannung innerhalb der Solaranlage 1 überführt.

Eine erneute Inbetriebnahme der Solaranlage 1 erfolgt durch erneutes Ausführen des erfindungsgemäßen Betriebsverfahrens.

### Bezugszeichenliste

- 1: Solaranlage
- 2: String
- 3: Wechselrichter
- 4: Solarmodul
- 10: Schaltelement
- 11: Verbindungsleitung
- 20: Schutzschaltung
- 21: Trennschalter
- 22: Kurzschlussschalter
- 23: Eingang
- 24: Ausgang
- 30: Trennvorrichtung
- 31, 32: Anschluss
- 40: Versorgungsschaltung
- 400: Kleinspannungsvorrichtung
- 401: DC/DC Wandler
- 402: Halbleiterschalter
- 403: Versorgungsanschlüsse
- 41: Trennschalter
- 42: Bandsperre
- 43: Bandpass
- 44: Steuereinheit
- 45: Überwachungsschaltung
- 46: Rückstromdiode
- 47: Halbleiterschalter
- 48: Versorgungsschaltung
- 51 - 55: Verfahrensschritt

## Patentansprüche

1. Vorrichtung (30) zur Trennung einer elektrischen Verbindung zwischen Solarmodulen (4) eines photovoltaischen Strings (2), umfassend:
- einen ersten Anschluss (31) und einen zweiten Anschluss (32) für ein jeweils zugeordnetes Solarmodul (4) des photovoltaischen Strings (2),
- einen Trennschalter (41), eine Bandsperre (42) und eine Versorgungsschaltung (40) zur Energieversorgung der Vorrichtung (30), die in einer Serienschaltung zueinander zwischen dem ersten und dem zweiten Anschluss (31, 32) angeordnet sind,
- einen Bandpass (43) zur Auskopplung eines hochfrequenten Steuersignals aus der elektrischen Verbindung, wobei der Bandpass (43) den Trennschalter (41) und die Bandsperre (42) parallel überbrückt, und
- eine Steuereinheit (44), die dazu eingerichtet ist, das hochfrequente Steuersignal zu empfangen und die Trennvorrichtung (30) in Abhängigkeit des hochfrequenten Steuersignals zu betreiben,
- wobei dem Trennschalter (41) oder der Teilserienschaltung des Trennschalters (41) und der Bandsperre (42) eine gegenüber einer Betriebsstromflussrichtung entgegengesetzt gepolte Rückstromdiode (46) parallel geschaltet ist.

2. Vorrichtung nach Anspruch 1, wobei der Trennschalter (41) ein Doppelkontakt-Serienrelais ist.

3. Vorrichtung nach Anspruch 2, wobei eine Überwachungsschaltung (45) mit einem Mittelpunkt des Doppelkontakt-Serienrelais verbunden ist.

4. Vorrichtung nach einem der vorangehenden Ansprüche, wobei der Trennschalter (41) ein bistabiles Relais ist.

5. Vorrichtung nach einem der vorangehenden Ansprüche, wobei dem Trennschalter (41) oder der Teilserienschaltung des Trennschalters (41) und der Bandsperre (42) ein erster Halbleiterschalter (47) zur Unterdrückung eines Schaltlichtbogens parallel geschaltet ist.

6. Vorrichtung nach einem der vorangehenden Ansprüche, wobei die Versorgungsschaltung (40) eine Kleinspannungsvorrichtung (400), insbesondere mit zwei antiparallel geschaltete Dioden aufweist, und wobei ein DC/DC-Wandler (401) mit der Kleinspannungsvorrichtung (400) verbunden und dazu eingerichtet ist, eine an der Kleinspannungsvorrichtung (400) abfallende Spannung in eine Versorgungsspannung U_{V} für die Trennvorrichtung (30) umzuwandeln.

7. Vorrichtung nach Anspruch 6, wobei der Kleinspannungsvorrichtung (400) weiterhin ein zweiter Halbleiterschalter (402) parallel geschaltet ist.

8. Solaranlage (1) mit einem Wechselrichter (3) und einem an den Wechselrichter (3) angeschlossenen photovoltaischen String (2) mit mindestens zwei seriell geschalteten Solarmodulen (4), wobei zwischen den Solarmodulen (4) eine Vorrichtung (30) nach einem der vorangehenden Ansprüche angeordnet ist.

9. Betriebsverfahren für eine Solaranlage (1), die einen Wechselrichter (3) und einen an den Wechselrichter (3) angeschlossenen photovoltaischen String (2) mit mindestens zwei seriell geschalteten Solarmodulen (4) aufweist, zwischen denen eine Vorrichtung (30) nach einem der Ansprüche 1 bis 7 angeordnet ist, wobei das Betriebsverfahren die Schritte umfasst:
- Bereitstellen einer initialen Energieversorgung für die Vorrichtung (30) bei geöffnetem Trennschalter (41) durch Aufprägen eines Stromflusses über den String (2) und Energieentnahme aus dem aufgeprägten Stromfluss über den String (2),
- Senden eines Einschaltsignals über den String (2),
- Schließen des Trennschalters (41) der Vorrichtung (30) in Reaktion auf das gesendete Einschaltsignal,
- wobei eine Energieversorgung der Vorrichtung (30) nach dem Schließen des Trennschalters (41) durch eine Energieentnahme aus dem Stromfluss über den String (2) erfolgt, und
- wobei das Aufprägen des Stromflusses das Aufprägen eines Rückstroms über den String (2) umfasst.

10. Betriebsverfahren nach Anspruch 9, wobei das Aufprägen des Stromflusses zusätzlich ein Anlegen einer Wechselspannung mit einer ersten Frequenz umfasst.

11. Betriebsverfahren nach einem der Ansprüche 9 bis 10, wobei nach dem Schließen des Trennschalters (41) der Vorrichtung (30) zunächst ein wiederholtes oder dauerhaftes Senden eines Lebenssignals über den String (2) erfolgt, und wobei der Trennschalter (41) geschlossen bleibt, solange das Lebenssignal gesendet wird und der Trennschalter (41) bei Wegfall des Lebenssignals öffnet.

12. Betriebsverfahren nach Anspruch 11, wobei das Senden des Lebenssignals ein Anlegen einer Wechselspannung mit einer zweiten, von der ersten Frequenz unterschiedlichen Frequenz umfasst.

13. Betriebsverfahren nach Anspruch 11, wobei das Senden des Lebenssignals ein Anlegen einer Wechselspannung mit einer zweiten Frequenz umfasst, die gleich der ersten Frequenz ist.

## Claims

1. An apparatus (30) for disconnecting an electrical connection between solar modules (4) of a photovoltaic string (2), comprising:
- a first terminal (31) and a second terminal (32) for a respectively assigned solar module (4) of the photovoltaic string (2),
- a circuit breaker (41), a band-stop filter (42) and a supply circuit (40) for supplying energy to the apparatus (30) arranged in a series circuit with respect to one another between the first and the second terminals (31, 32),
- a bandpass filter (43) for coupling out a high-frequency control signal from the electrical connection, wherein the bandpass filter (43) bridges the circuit breaker (41) and the band-stop filter (42) in parallel, and
- a control unit (44) configured to receive the high-frequency control signal and to operate the disconnection apparatus (30) depending on the high-frequency control signal,
- wherein a reverse current diode (46) that is oppositely polarized relative to an operating current flow direction is connected in parallel with the circuit breaker (41) or the partial series circuit comprising the circuit breaker (41) and the band-stop filter (42).

2. The apparatus as claimed in claim 1, wherein the circuit breaker (41) is a double contact series relay.

3. The apparatus as claimed in claim 2, wherein a monitoring circuit (45) is connected to a midpoint of the double contact series relay.

4. The apparatus as claimed in any of the preceding claims, wherein the circuit breaker (41) is a bi-stable relay.

5. The apparatus as claimed in any of the preceding claims, wherein a first semiconductor switch (47) for suppressing a switching arc is connected in parallel with the circuit breaker (41) or the partial series circuit comprising the circuit breaker (41) and the band-stop filter (42).

6. The apparatus as claimed in any of the preceding claims, wherein the supply circuit (40) comprises an extra-low-voltage apparatus (400), in particular having two antiparallel-connected diodes, and wherein a DC/DC converter (401) is connected to the extra-low-voltage apparatus (400) and configured to convert a voltage dropped across the extra-low-voltage apparatus (400) into a supply voltage Uᵥ for the disconnection apparatus (30).

7. The apparatus as claimed in claim 6, wherein a second semiconductor switch (402) is furthermore connected in parallel with the extra-low-voltage apparatus (400).

8. A solar installation (1) comprising an inverter (3) and a photovoltaic string (2) comprising at least two series-connected solar modules (4), said photovoltaic string (2) being connected to the inverter (3), wherein an apparatus (30) as claimed in any of the preceding claims is arranged between the solar modules (4).

9. An operating method for a solar installation (1) comprising an inverter (3) and a photovoltaic string (2) comprising at least two series-connected solar modules (4), said photovoltaic string (2) being connected to the inverter (3), an apparatus (30) as claimed in any of claims 1 to 7 being arranged between the solar modules (4), wherein the operating method comprises the following steps:
- providing an initial energy supply for the apparatus (30) with the circuit breaker (41) being open by impressing a current flow via the string (2) and drawing energy from the impressed current flow via the string (2),
- transmitting a switch-on signal via the string (2),
- closing the circuit breaker (41) of the apparatus (30) in reaction to the transmitted switch-on signal,
- wherein energy is supplied to the apparatus (30) after the closing of the circuit breaker (41) by energy being drawn from the current flow via the string (2), and
- wherein impressing the current flow comprises impressing a reverse current via the string (2).

10. The operating method as claimed in claim 9, wherein impressing the current flow additionally comprises applying an AC voltage having a first frequency.

11. The operating method as claimed in either of claims 9 and 10, wherein after closing the circuit breaker (41) of the apparatus (30), firstly a live signal is transmitted repeatedly or permanently via the string (2), and wherein the circuit breaker (41) remains closed as long as the live signal is transmitted, and the circuit breaker (41) opens upon the live signal being discontinued.

12. The operating method as claimed in claim 11, wherein transmitting the live signal comprises applying an AC voltage having a second frequency different than the first frequency.

13. The operating method as claimed in claim 11, wherein transmitting the live signal comprises applying an AC voltage having a second frequency equal to the first frequency.

## Revendications

1. Dispositif (30) de sectionnement d'une liaison électrique entre des modules solaires (4) d'une chaîne photovoltaïque (2), comprenant :
- une première borne (31) et une deuxième borne (32) pour un module solaire (4) respectivement associé de la chaîne photovoltaïque (2),
- un sectionneur (41), un filtre coupe-bande (42) et un circuit d'alimentation (40) servant à l'alimentation en énergie du dispositif (30), lesquels sont branchés en série les uns avec les autres entre la première et la deuxième borne (31, 32),
- un filtre passe-bande (43) destiné à découpler un signal de commande à haute fréquence de la liaison électrique, le filtre passe-bande (43) réalisant un pontage parallèle du sectionneur (41) et du filtre coupe-bande (42), et
- une unité de commande (44) qui est conçue pour recevoir le signal de commande à haute fréquence et pour faire fonctionner le dispositif de sectionnement (30) en fonction du signal de commande à haute fréquence,
- une diode de retour de courant (46) à la polarité inversée par rapport à un sens de circulation du courant de service étant branchée en parallèle avec le sectionneur (41) ou le circuit série partiel composé du sectionneur (41) et du filtre coupe-bande (42).

2. Dispositif selon la revendication 1, le sectionneur (41) étant un relais série à double contact.

3. Dispositif selon la revendication 2, un circuit de surveillance (45) étant relié au point milieu du relais série à double contact.

4. Dispositif selon l'une des revendications précédentes, le sectionneur (41) étant un relais bistable.

5. Dispositif selon l'une des revendications précédentes, un premier commutateur semiconducteur (47) destiné à inhiber un arc électrique de commutation étant branché en parallèle avec le sectionneur (41) ou le circuit série partiel composé du sectionneur (41) et du filtre coupe-bande (42).

6. Dispositif selon l'une des revendications précédentes, le circuit d'alimentation (40) possédant un dispositif à basse tension (400), comprenant notamment deux diodes branchées en tête-bêche, et un convertisseur CC/CC (401) étant relié au dispositif à basse tension (400) et conçu pour convertir une tension de chute aux bornes du dispositif à basse tension (400) en une tension d'alimentation U_{V} pour le dispositif de sectionnement (30).

7. Dispositif selon la revendication 6, un deuxième commutateur semiconducteur (402) étant en outre branché en parallèle avec le dispositif à basse tension (400).

8. Installation solaire (1) comprenant un onduleur (3) et une chaîne photovoltaïque (2) raccordée à l'onduleur (3), laquelle comprend au moins deux modules solaires (4) branchés en série, un dispositif (30) selon l'une des revendications précédentes étant disposé entre les modules solaires (4).

9. Procédé de fonctionnement pour une installation solaire (1), laquelle possède un onduleur (3) et une chaîne photovoltaïque (2) raccordée à l'onduleur (3), laquelle comprend au moins deux modules solaires (4) branchés en série, entre lesquels est disposé un dispositif (30) selon l'une des revendications 1 à 7, le procédé de fonctionnement comprenant les étapes suivantes :
- fourniture d'une alimentation en énergie initiale pour le dispositif (30) avec le sectionneur (41) ouvert par mise en place d'un flux de courant par le biais de la chaîne (2) et prélèvement d'énergie du flux de courant mis en place par le biais de la chaîne (2),
- envoi d'un signal de mise en circuit par le biais de la chaîne (2),
- fermeture du sectionneur (41) du dispositif (30) en réaction au signal de mise en circuit envoyé,
- une alimentation en énergie du dispositif (30) après la fermeture du sectionneur (41) s'effectuant par un prélèvement d'énergie du flux de courant par le biais de la chaîne (2), et
- la mise en place du flux de courant comprenant la mise en place d'un courant de retour par le biais de la chaîne (2).

10. Procédé de fonctionnement selon la revendication 9, la mise en place du flux de courant comprenant en outre l'application d'une tension alternative ayant une première fréquence.

11. Procédé de fonctionnement selon l'une des revendications 9 et 10, un envoi répété ou continu d'un signal d'activité par le biais de la chaîne (2) ayant tout d'abord lieu après la fermeture du sectionneur (41) du dispositif (30), et le sectionneur (41) restant fermé tant que le signal d'activité est envoyé et le sectionneur (41) s'ouvrant en cas de suppression du signal d'activité.

12. Procédé de fonctionnement selon la revendication 11, l'envoi du signal d'activité comprenant une application d'une tension alternative ayant une deuxième fréquence différente de la première fréquence.

13. Procédé de fonctionnement selon la revendication 11, l'envoi du signal d'activité comprenant une application d'une tension alternative ayant une deuxième fréquence qui est égale à la première fréquence.
